# FASCICULE DE BREVET EUROPEEN

(11) **EP 1 524 767 B1**
(45) Date de publication et mention de la délivrance du brevet: **05.01.2011**
(21) Numéro de dépôt: 04105052.7
(22) Date de dépôt: 14.10.2004
(51) Int. Cl.: H01L 29/04, H03K 17/04, H01L 29/74

(54) **Structure de commutateur SCR à commande HF**
Thyristorstruktur mit HF-Ansteuerung
RF-driven SCR structure

(30) Priorité: 17.10.2003 FR 0350703
(43) Date de publication de la demande: 20.04.2005
(73) Titulaire: ST MICROELECTRONICS S.A., 92120 Montrouge (FR)
(72) Inventeur: Menard, Samuel, 37000, Tours (FR); Mauriac, Christophe, 37300 Joue les Tours (FR)
(74) Mandataire: de Beaumont, Michel

(56) Documents cités:
- EP-A- 0 930 711
- FR-A- 1 384 940
- US-A- 3 140 963
- PATENT ABSTRACTS OF JAPAN vol. 007, no. 247 (E-208), 2 novembre 1983 (1983-11-02) & JP 58 134471 A (MITSUBISHI DENKI KK), 10 août 1983 (1983-08-10)

## Description

La présente invention concerne de façon générale des commutateurs verticaux de type SCR. On entend par commutateurs de type SCR des composants tels que des thyristors, des triacs et autres commutateurs bidirectionnels commandés comprenant au moins quatre ou cinq couches semiconductrices de types de dopage alternés.

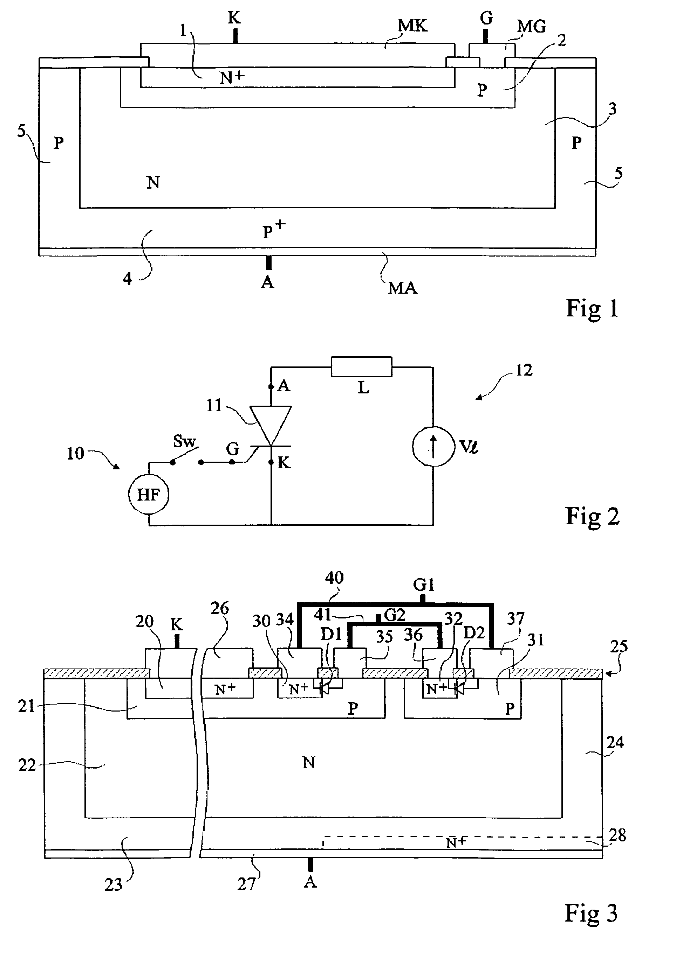

La figure 1 est une vue en coupe d'une structure classique de thyristor. Le thyristor comprend une région de cathode 1 de type N, formée dans un caisson 2 de type P, lui-même formé dans un substrat 3 faiblement dopé de type N, et une région d'anode 4 de type P du côté de la face arrière. On a représenté, à titre d'exemple, un thyristor dans lequel le substrat 3 est entouré d'un mur d'isolement 5 de type P en contact avec l'anode 4. Le caisson 2 de type P correspond à une zone de gâchette de cathode. La face avant du thyristor est recouverte d'une couche isolante 6. Une métallisation de cathode MK reliée à une borne de cathode K est en contact avec la région de cathode 1. Une métallisation de gâchette MG reliée à une borne de gâchette G est en contact avec le caisson 2. La face arrière du composant est revêtue d'une métallisation d'anode MA reliée à une borne d'anode A. Le document FR-A-1 384 940 divulgue un exemple d'un tel composant.

La région de cathode 1 ainsi que les portions du caisson 2, du substrat 3 et de la région d'anode 4 situées au-dessous constituent une zone de puissance à travers laquelle passe un courant important quand le thyristor est activé. Les éléments du thyristor situés à l'aplomb et à proximité de la métallisation de gâchette MG constituent une zone de commande qui est active lors du déclenchement du thyristor.

La figure 2 est un schéma d'un circuit de commande HF 10 d'un thyristor 11 inséré dans un circuit de puissance 12, tel que décrit dans la demande de brevet français non publiée numéro 0215322 de la demanderesse déposée le 4 décembre 2002 (B5748). Le circuit de puissance 12 est représenté schématiquement par un générateur de tension V1 et une charge L en série entre l'anode et la cathode du thyristor 11. Le circuit de commande 10 est destiné à appliquer un courant entre la gâchette G et la cathode K du thyristor et comprend essentiellement en série un générateur de tension haute fréquence HF sinusoïdal et un interrupteur Sw. La demande de brevet susmentionnée expose que, même si l'énergie fournie par le circuit de commande lors de chaque période est inférieure à l'énergie nécessaire pour déclencher le thyristor, celui-ci se déclenche, de façon surprenante, au bout d'un certain nombre de périodes.

Quand l'énergie fournie par le circuit de commande est bien plus faible que l'énergie nécessaire pour déclencher le thyristor, le temps d'activation du commutateur peut néanmoins être relativement long.

De plus, l'épaisseur et le profil de dopage des éléments du thyristor de la figure 1 sont le plus souvent optimisés afin d'améliorer la conductivité du thyristor ainsi que sa tenue en tension, ce qui va souvent à l'encontre d'une optimisation de l'amorçage du commutateur. Les caractéristiques structurelles du thyristor ne sont donc pas favorables à la réduction du temps d'activation.

La commande d'un thyristor par un signal haute fréquence permet de prévoir un isolement galvanique entre le générateur de tension HF et le thyristor en plaçant un premier condensateur entre l'interrupteur Sw et la gâchette G du thyristor et un second condensateur entre le générateur HF et la cathode K du thyristor. Le premier condensateur peut être intégré dans le thyristor en prévoyant une couche isolante entre la métallisation de gâchette et la zone semiconductrice de gâchette. Le second condensateur ne peut par contre pas être intégré de façon similaire car un condensateur ne peut être placé sur un chemin "de puissance" où passent de forts courants continus ou à la fréquence, faible, du secteur. Un isolement galvanique complet nécessite donc de prévoir un condensateur discret entre le générateur HF et la cathode du thyristor. Or de façon générale on souhaite plutôt diminuer le nombre de composants discrets pour des raisons de coût, de place et de fiabilité.

Un objet de la présente invention est de prévoir un commutateur de type SCR pouvant être activé rapidement avec une énergie d'activation réduite.

Un autre objet de la présente invention est de prévoir un tel commutateur dont le circuit de commande puisse être isolé galvaniquement du circuit de puissance.

Pour atteindre ces objets, la présente invention prévoit un commutateur vertical de type SCR comprenant une zone de commande comprenant une première région de commande formant une première diode avec une première région ou couche voisine, dans lequel :
la zone de commande comprend en outre une seconde région de commande formant une seconde diode avec une seconde région ou couche voisine,
un contact est formé sur chacune des première et seconde régions de commande et sur chacune des première et seconde régions ou couches voisines,
lesdits contacts sont connectés à des bornes d'application d'une tension alternative de commande de sorte que, quand une tension alternative est appliquée, chacune des deux diodes soit alternativement conductrice.

Selon un mode de réalisation de la présente invention, le commutateur vertical comprend au moins quatre couches semiconductrices "principales" de types de dopage alternés à travers lesquelles un courant important est susceptible de passer de la face avant à la face arrière entre deux bornes principales, et dans lequel les première et deuxième régions de commande sont formées chacune soit dans l'une des couches principales soit dans un caisson de commande formé dans l'une des couches principales, les deux régions de commande formant avec la couche principale ou le ou les caissons de commande dans lesquels elles sont formées deux diodes susceptibles chacune d'amorcer le commutateur, et dans lequel, pour chaque diode, l'électrode correspondant à une région de commande est reliée à une première borne de commande par un desdits contacts, l'autre électrode étant reliée à une borne principale ou/et à une seconde borne de commande par un desdits contacts, le commutateur pouvant être activé par un circuit appliquant une tension alternative telle que chacune des deux diodes soit alternativement conductrice.

Selon un mode de réalisation de la présente invention, la première couche principale est formée du côté de la face avant dans la deuxième couche principale, la deuxième couche et éventuellement la troisième et la quatrième couches principales débouchant du côté de la face avant, et les deux régions de commande sont formées chacune dans l'une des deuxième, troisième ou quatrième couches, et le ou les caissons de commande sont formés dans l'une des troisième ou quatrième couches principales.

Selon un mode de réalisation de la présente invention, le commutateur est de type thyristor et comprend quatre couches principales : une région de cathode d'un premier type de dopage du côté de la face supérieure, formée dans un caisson d'un second type de dopage, lui-même formé dans un substrat du premier type de dopage, et une région d'anode du second type de dopage formée du côté de la face arrière, la région de cathode étant reliée à une borne principale de cathode, la région d'anode étant reliée à une borne principale d'anode.

Selon un mode de réalisation de la présente invention, les deux régions de commande sont des régions du premier type de dopage formées dans ledit caisson, une métallisation reliée à une seconde borne de commande étant en contact avec ledit caisson.

Selon un mode de réalisation de la présente invention, les deux régions de commande sont des première et seconde régions du premier type de dopage, la première région étant formée dans ledit caisson, la seconde région étant formée dans un second caisson du second type de dopage formé dans ledit substrat, la première région étant reliée au second caisson et à une des bornes de commande, la seconde région étant connectée audit caisson et à l'autre borne de commande.

Selon un mode de réalisation de la présente invention, le commutateur est de type triac et comprend cinq couches principales : une première région d'un premier type de dopage, formée dans un caisson d'un second type de dopage, lui-même formé dans un substrat du premier type de dopage, une couche du second type de dopage accolée à la partie inférieure du substrat et une seconde région du premier type de dopage formée dans la couche du côté de la face arrière, la première région et le caisson étant reliés en face avant à une borne principale, la seconde région et ladite couche étant reliées en face arrière à l'autre borne principale.

Selon un mode de réalisation de la présente invention, les deux régions de commande sont des première et seconde régions du premier type de dopage, la première région étant formée dans ledit caisson, la seconde région étant formée dans un second caisson du second type de dopage formé dans ledit substrat, la première région étant connectée au second caisson et à une des bornes de commande, la seconde région étant connectée audit caisson et à l'autre borne de commande.

Selon un mode de réalisation de la présente invention, les deux régions de commande sont des première et seconde régions du premier type de dopage, formées respectivement dans des second et troisième caissons du second type de dopage formés dans ledit substrat, la première région étant reliée au troisième caisson et à une des bornes de commande, la seconde région étant reliée au deuxième caisson et à l'autre borne de commande.

Selon un mode de réalisation de la présente invention, les deux régions de commande sont des régions du premier type de dopage formées dans ledit caisson.

Selon un mode de réalisation de la présente invention, le commutateur est de type bidirectionnel commandé, dans lequel la zone de commande est placée dans la partie supérieure d'un mur d'isolement ou au voisinage immédiat de celle-ci.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe, précédemment décrite, d'un thyristor selon l'art antérieur ;
la figure 2 est un schéma, précédemment décrit, d'un circuit de commande HF et d'utilisation d'un thyristor selon l'art antérieur ;
la figure 3 est une vue en coupe d'un thyristor selon la présente invention ;
la figure 4 est un schéma d'un circuit de commande HF et d'utilisation d'un thyristor selon un mode de réalisation de la présente invention ;
la figure 5 est un chronogramme des tensions aux bornes de deux diodes du thyristor de la figure 4 ;
la figure 6 est un chronogramme du courant traversant le thyristor de la figure 4 ;
la figure 7 est une vue en coupe d'un thyristor selon un mode de réalisation de la présente invention ;
la figure 8 est un schéma d'un circuit de commande et d'utilisation d'un thyristor tel que représenté en figure 7 ;
la figure 9 est une vue en coupe d'un triac selon l'art antérieur ;
la figure 10 est une vue en coupe d'un triac selon un mode de réalisation de la présente invention ;
la figure 11 est une vue en coupe d'un triac selon un autre mode de réalisation de la présente invention ;
la figure 12 est un schéma d'un circuit de commande et d'utilisation d'un triac tel que représenté en figure 10 ou 11 ;
la figure 13 est une vue en coupe d'un triac selon un autre mode de réalisation de la présente invention ;
la figure 14 est une vue de dessus du triac représenté en figure 13 ;
la figure 15 est un schéma d'un circuit de commande et d'utilisation d'un triac tel que représenté en figures 13 et 14 ;
la figure 16 est une vue en coupe d'un commutateur bidirectionnel selon l'art antérieur ;
la figure 17 est une vue en coupe partielle illustrant la zone de déclenchement d'un commutateur bidirectionnel selon un mode de réalisation de la présente invention.

Comme cela est habituel dans la représentation des circuits intégrés, les figures 1, 3, 7, 9 à 11, 13, 14, 16 et 17 ne sont pas tracées à l'échelle.

La présente invention vise à transformer la structure d'un commutateur SCR afin de constituer deux diodes susceptibles d'amorcer le commutateur. Un signal haute fréquence est appliqué aux bornes de chacune des deux diodes afin que chaque diode soit alternativement conductrice. L'utilisation des deux alternances du signal HF permet de réduire le temps nécessaire à l'activation du commutateur SCR. Divers modes de réalisation d'un commutateur selon la présente invention seront décrits ci-après en prenant comme exemple un thyristor, un triac et autre commutateur bidirectionnel.

### 1. THYRISTOR

### 1.1 Premier mode de réalisation d'un thyristor

La figure 3 est une vue en coupe d'un thyristor selon un mode de réalisation de la présente invention. La zone de puissance du thyristor est sensiblement identique à celle du thyristor classique de la figure 1 et comprend une région de cathode 20 de type N fortement dopée, formée dans un caisson 21 de type P, lui-même formé dans un substrat 22 de type N faiblement dopé, et une région d'anode 23 de type P du côté de la face arrière du thyristor. Le substrat 22 est entouré d'un mur d'isolement 24 de type P en contact avec la région d'anode 23. La face avant du thyristor est recouverte d'une couche isolante 25 sauf en certaines zones de contact. Une métallisation de cathode 26 reliée à une borne de cathode K est en contact avec la région de cathode 20. La face arrière du composant est revêtue d'une métallisation d'anode 27 reliée à une borne d'anode A.

Les éléments du thyristor spécifiques de la présente invention font partie d'une zone de commande définie ci-après. Une région 30 de type N fortement dopée est formée dans le caisson 21 de type P. Un caisson 31 de type P est formé dans le substrat 22, à droite du caisson 21 dans cet exemple. Une région 32 de type N fortement dopée est formée dans le caisson 31. Des métallisations 34, 35, 36 et 37 sont respectivement en contact avec la région 30, le caisson 21, la région 32 et le caisson 31. Dans cet exemple, la métallisation 34 est reliée à la métallisation 37 par une ligne conductrice 40 représentée schématiquement, et la métallisation 35 est reliée à la métallisation 36 par une ligne conductrice 41. Les lignes 40 et 41 peuvent être formées de façon classique sur une couche isolante recouvrant la structure active du thyristor. Les lignes 40 et 41 sont reliées respectivement à deux bornes de gâchette G1 et G2.

La région 30 de type N et le caisson 21 de type P constituent une diode D1. La région 32 de type N et le caisson 31 de type P constituent une diode D2. Les diodes D1 et D2 sont connectées selon des polarités opposées entre les bornes de gâchette G1 et G2.

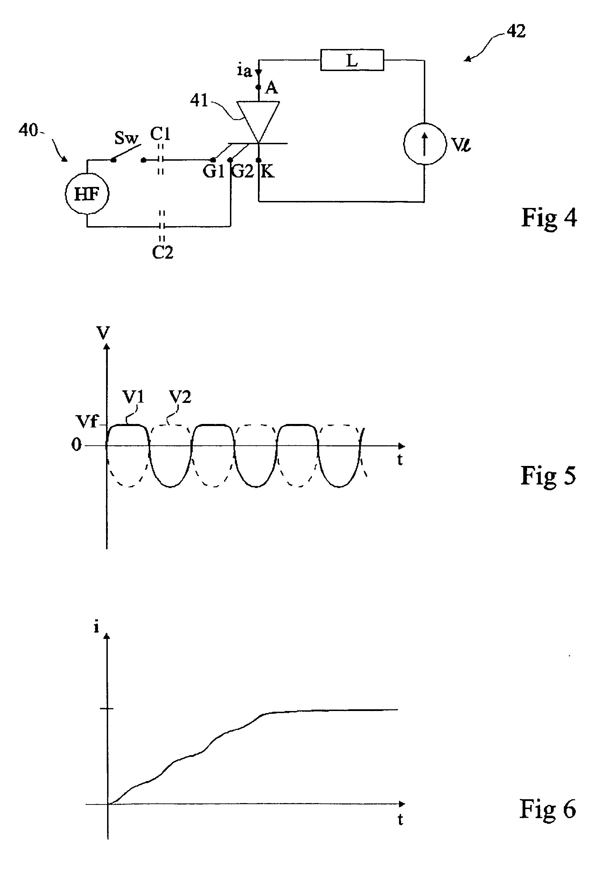

La figure 4 est un schéma d'un circuit de commande 40 d'un thyristor 41 inséré dans un circuit de puissance 42. Le thyristor 41 est un thyristor selon la présente invention ayant la structure représentée en figure 3. Contrairement à un thyristor classique, le thyristor 41 comprend deux bornes de gâchette G1 et G2. Le circuit de puissance 42 est représenté comme précédemment par un générateur de tension V1 et une charge L en série entre l'anode A et la cathode K du thyristor. Le circuit de commande 40 est destiné à appliquer un signal haute fréquence entre les bornes de gâchette G1 et G2 du thyristor et comprend un générateur de tension haute fréquence sinusoïdal en série avec un interrupteur Sw.

La figure 5 est un chronogramme des tensions V1 et V2 aux bornes respectivement des diodes D1 et D2 du thyristor 41 tel que représenté en figure 3. Sur une alternance du signal HF, la diode D1 est conductrice et la tension V1 est sensiblement égale à la chute de tension en direct Vf de la diode. Durant cette même alternance, la diode D2 est non conductrice et la tension V2 suit les variations sinusoïdales du signal haute fréquence. Lors de l'alternance suivante du signal HF, la diode D2 est conductrice et la tension V2 est sensiblement égale à la tension Vf. Durant cette même alternance, la diode D1 est non conductrice et la tension V1 suit les variations du signal HF. Les deux alternances décrites correspondent à une période du signal haute fréquence. Ces deux alternances se répètent tant que l'interrupteur Sw est passant, c'est-à-dire tant que le circuit de commande 40 est actif. Lorsqu'une des diodes D1 et D2 est conductrice, des charges sont "injectées" au voisinage de la jonction bloquante du thyristor. L'injection sensiblement continue de charges produit une accumulation de charges et permet de faire naître progressivement un courant entre l'anode A et la cathode K du thyristor 41.

La figure 6 est un chronogramme du courant anode-cathode i du thyristor 41. Le courant i est initialement nul puis après activation du circuit de commande 40, il augmente progressivement jusqu'à ce que le signal de gâchette ait complètement amorcé le thyristor.

Comme l'illustre la figure 3, afin d'améliorer l'efficacité des charges injectées, on pourra prévoir, du côté de la face arrière du composant, une zone 28 fortement dopée de type N dans la région 23 de type P, à l'aplomb du caisson 31 et de la partie de droite du caisson 21, dans laquelle est formée la région 30, ce qui favorise la localisation des charges injectées vers la zone de puissance du thyristor.

Dans le cas où l'on souhaite isoler galvaniquement le circuit de commande 40 du thyristor 41, on pourra prévoir deux condensateurs C1 et C2, représentés en pointillés en figure 4, respectivement entre la borne de gâchette G1 et l'interrupteur Sw et entre la borne de gâchette G2 et le générateur HF. Les condensateurs C1 et C2 peuvent être intégrés dans le thyristor 41, par exemple en prévoyant quatre fines couches isolantes entre les métallisations 34, 35, 36, 37 et respectivement la région 30, le caisson 21, la région 32 et le caisson 31.

### 1.2 Second mode de réalisation d'un thyristor

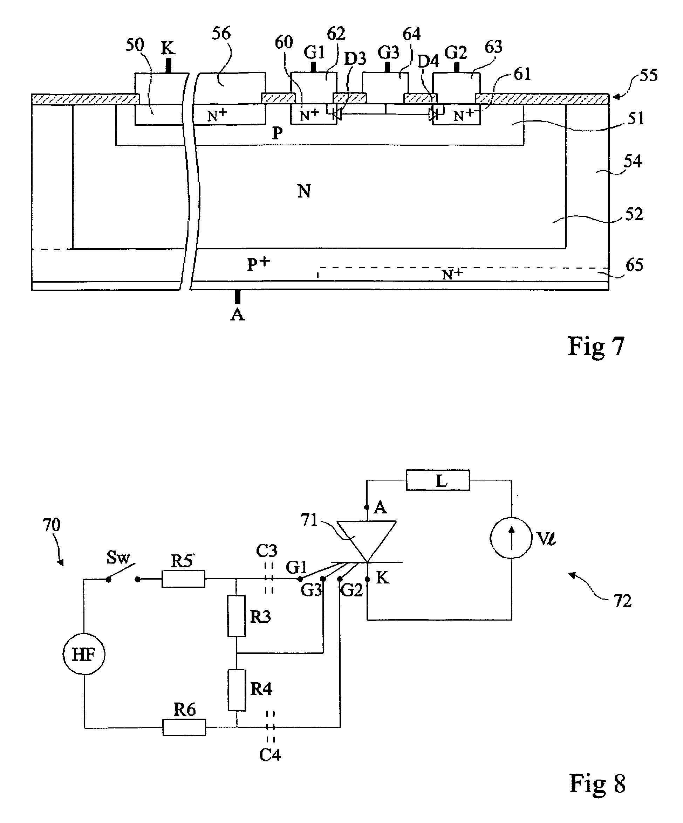

La figure 7 est une vue en coupe d'un thyristor selon un autre mode de réalisation de la présente invention. La zone de puissance du thyristor est sensiblement identique à celle du thyristor classique de la figure 1 et comprend une région de cathode 50 de type N fortement dopée, formée dans un caisson 51 de type P, lui-même formé dans un substrat 52 de type N faiblement dopé, et une région d'anode 53 de type P fortement dopée du côté de la face arrière du thyristor. Le substrat 52 est entouré d'un mur d'isolement 54 de type P en contact avec la région d'anode 53. La face avant du thyristor est recouverte d'une couche isolante 55 excepté en divers endroits de contact. Une métallisation de cathode 56 reliée à une borne K est en contact avec la région de cathode 50. La face arrière du composant est revêtue d'une métallisation d'anode 57 reliée à une borne d'anode A.

Les éléments du thyristor spécifiques de la présente invention font partie d'une zone de commande définie ci-après. Deux régions 60 et 61 de type N fortement dopées sont formées dans le caisson 51, à droite de la région 50 dans cet exemple. Deux métallisations 62 et 63 sont en contact respectivement avec les régions 60 et 61. Une métallisation 64 est en contact avec une partie du caisson 51 située entre les régions 60 et 61 de type N. Les métallisations 62, 63 et 64 sont respectivement reliées à trois bornes de gâchette G1, G2 et G3.

La région 60 de type N et le caisson 51 de type P constituent une diode D3 connectée aux bornes de gâchette G1 et G3. La région 61 de type N et le caisson 51 de type P constituent une diode D4 connectée aux bornes de gâchette G2 et G3.

La figure 8 est un schéma d'un circuit de commande 70 d'un thyristor 71 inséré dans un circuit de puissance 72. Le thyristor 71 a la structure du thyristor représenté en figure 7. Le circuit de puissance 72 comprend un générateur de tension V1 et une charge L en série entre l'anode A et la cathode K du thyristor 71. Le thyristor 71 est relié au circuit de commande 72, constitué comme précédemment d'un interrupteur Sw et d'un générateur HF, par l'intermédiaire d'un ensemble de résistances. Une résistance R3 est placée entre les bornes de gâchette G1 et G3. Une résistance R4 est placée entre les bornes de gâchette G2 et G3. Une résistance R5 est placée entre la borne de gâchette G1 et l'interrupteur Sw. Une résistance R6 est placée entre la borne de gâchette G2 et le générateur HF.

Lorsque le circuit de commande 72 est actif, c'est-à-dire que l'interrupteur Sw est fermé, la séquence d'activation des diodes D3 et D4 est la suivante. Lors d'une alternance HF, le courant fourni par le générateur HF circule de R5 vers R6 en passant à travers R3 et R4. Lors de l'alternance suivante du générateur HF, le courant circule à l'inverse de la résistance R6 vers la résistance R5 en passant à travers R3 et R4. La tension aux bornes de la diode D3 est égale à la tension aux bornes de la résistance R3. De même, la tension aux bornes de la diode D4 est égale à la tension aux bornes de la résistance R4. Lorsque le courant circule de R5 vers R6, la diode D4 est conductrice et quand le courant circule de R6 vers R5, la diode D3 est conductrice. Lorsqu'une des diodes D3 et D4 est conductrice, des charges sont "injectées" au voisinage de la jonction bloquante du thyristor. L'injection sensiblement continue de charges permet d'accumuler rapidement des charges et de faire naître progressivement un courant entre l'anode A et la cathode K du thyristor 70.

Comme précédemment, afin d'améliorer le phénomène d'injection, on prévoit de préférence une zone 65 de type N fortement dopée dans la région 53 de type P à l'aplomb de la partie de droite du caisson 51 dans laquelle sont formées les régions 60 et 61.

Les résistances R3 et R4 et le thyristor 70 pourront facilement être formés dans un même composant semiconducteur. Dans ce cas, le composant comprend quatre bornes : deux bornes d'anode et de cathode, A et K, et deux bornes de gâchette, G1 et G2.

De plus, dans le cas où l'on souhaite isoler galvaniquement le circuit de commande 70 du thyristor 71, on pourra prévoir deux condensateurs C3 et C4, représentés en pointillés, respectivement entre l'interrupteur Sw et la résistance R5 et entre le générateur HF et la résistance R6. De même, les condensateurs C3 et C4 peuvent être intégrés dans un composant comprenant les résistances R3 et R4 et le thyristor 71.

### 2. TRIAC

### 2.1 Premier mode de réalisation d'un triac

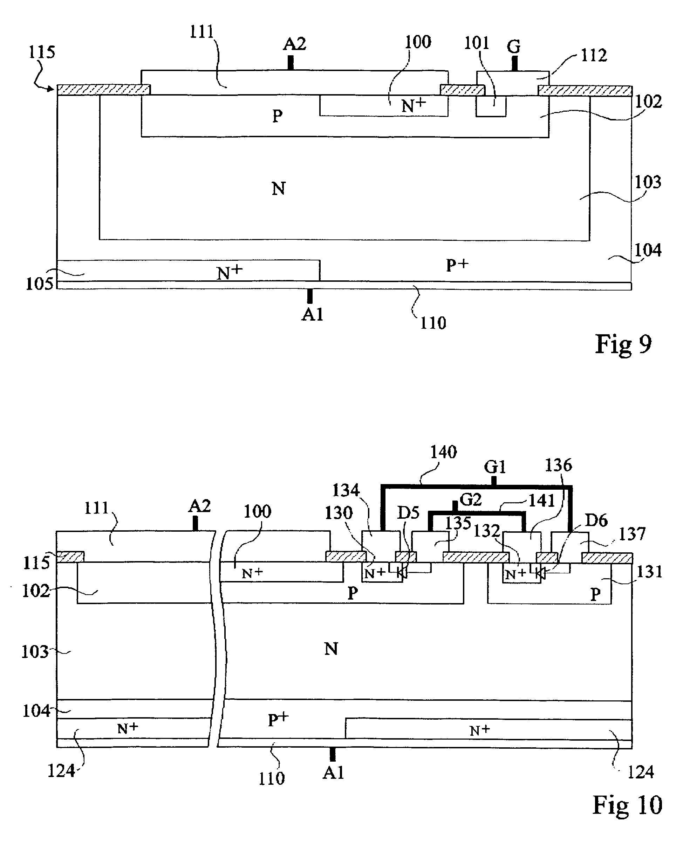

La figure 9 est une vue en coupe d'une structure classique de triac. Le triac comprend deux régions 100 et 101 de type N fortement dopées, formées dans un caisson 102 de type P, lui-même formé dans un substrat 103 faiblement dopé de type N, une couche 104 fortement dopée de type P accolée à la partie inférieure du substrat 103, et une région 105 de type N fortement dopée formée dans la couche 104 du côté de la face arrière. La face arrière du composant est revêtue d'une métallisation 110 reliée à une borne A1. Une métallisation 111 reliée à une borne A2 est en contact avec une grande partie du caisson 102 de type P et avec la région 100 de type N. Une métallisation 112 reliée à une borne de gâchette G est en contact avec une petite partie du caisson 102 et avec la région 101. Les métallisations 111 et 112 sont entourées d'une couche isolante recouvrant la face avant du triac. Les régions 100 et 101 sont décalées l'une par rapport à l'autre de façon que la portion de la couche 104 située à l'aplomb de la région 100 soit directement en contact avec la métallisation 110 et que la portion du caisson 102 non occupée par la région 100 soit située au-dessus de la région 105.

Lorsque l'on souhaite rendre conducteur un triac, on injecte ou on extrait un courant par la borne de gâchette G ce qui a pour effet de mettre en conduction l'un des thyristors constitutifs du triac.

La figure 10 est une vue en coupe d'un triac selon un mode de réalisation de la présente invention. La zone de puissance du triac est sensiblement identique à celle du triac de la figure 9. La région 105 est remplacée par une région 124 qui s'étend sur toute la face arrière du composant sauf sensiblement en regard de la région 110.

Les éléments spécifiques à un triac selon la présente invention font partie de la zone de commande définie ci-après. Une région 130 de type N fortement dopée est formée dans le caisson 102 sur la droite de la région 110 dans cet exemple. Un caisson 131 de type P est formé dans le substrat 103, sur la droite du caisson 102. Une région 132 de type N fortement dopée est formée dans le caisson 131. Quatre métallisations 134, 135, 136 et 137 sont en contact respectivement avec la région 130, une portion du caisson 102, la région 132 et le caisson 131. Les métallisations 134 et 137 sont reliées par une ligne conductrice 140 représentée schématiquement. De même, les métallisations 135 et 136 sont reliées par une ligne conductrice 141. Les lignes conductrices 140 et 141 sont respectivement reliées à des bornes de gâchette G1 et G2.

La région 130 de type N et le caisson 102 de type P constituent une diode D5. La région 132 de type N et le caisson 131 de type P constituent une diode D6. Les diodes D5 et D6 sont alternativement polarisées à l'état passant par un signal HF sur les bornes de gâchette G1 et G2.

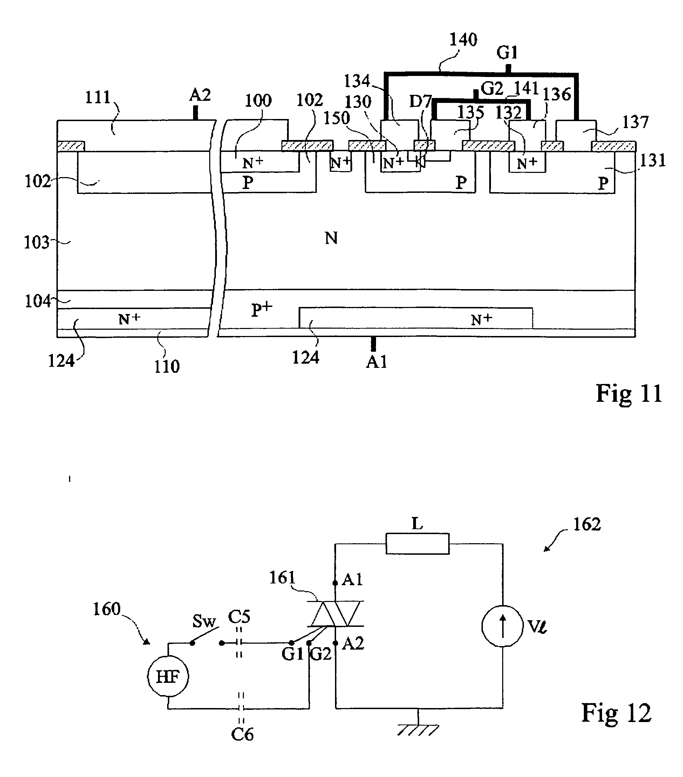

La figure 11 est une vue en coupe d'un triac selon une variante de réalisation du triac représenté en figure 10. La région 130 est formée non pas dans le caisson 102 mais dans un caisson spécifique 150 de type P placé dans cet exemple entre le caisson 102 et le caisson 131. La métallisation 135 est en contact avec le caisson 150. La région 130 de type N et le caisson 150 de type P constituent une diode D7. Contrairement au triac de la figure 10 dans lequel l'anode de la diode D5 est reliée à la borne A2 et à la borne G2, l'anode de la diode D7 est uniquement reliée à la borne G2.

La figure 12 est un schéma d'un circuit de commande 160 d'un triac 161 inséré dans un circuit de puissance 162. Le triac 161 est tel que représenté en figure 10 ou 11. Contrairement à un triac classique, le triac comprend deux bornes de gâchette G1 et G2. Le circuit de puissance 162 comprend un générateur de tension V1 et une charge L en série entre les bornes A1 et A2 du triac. Les bornes de gâchette G1 et G2 du triac sont reliées au circuit de commande 162 constitué d'un générateur haute fréquence sinusoïdal en série avec un interrupteur Sw.

Dans le cas où l'on souhaite isoler galvaniquement le circuit de commande 162 du triac 160, on pourra placer des condensateurs C5 et C6 respectivement entre la borne de gâchette G1 et l'interrupteur Sw et entre la borne de gâchette et le générateur HF. Les condensateurs C5 et C6 peuvent être intégrés dans le triac 161 en prévoyant par exemple une fine couche diélectrique entre les métallisations 134, 135, 136 et 137 et les régions d'anode et de cathode des diodes D5, D6 et D7.

### 2.2 Second mode de réalisation d'un triac

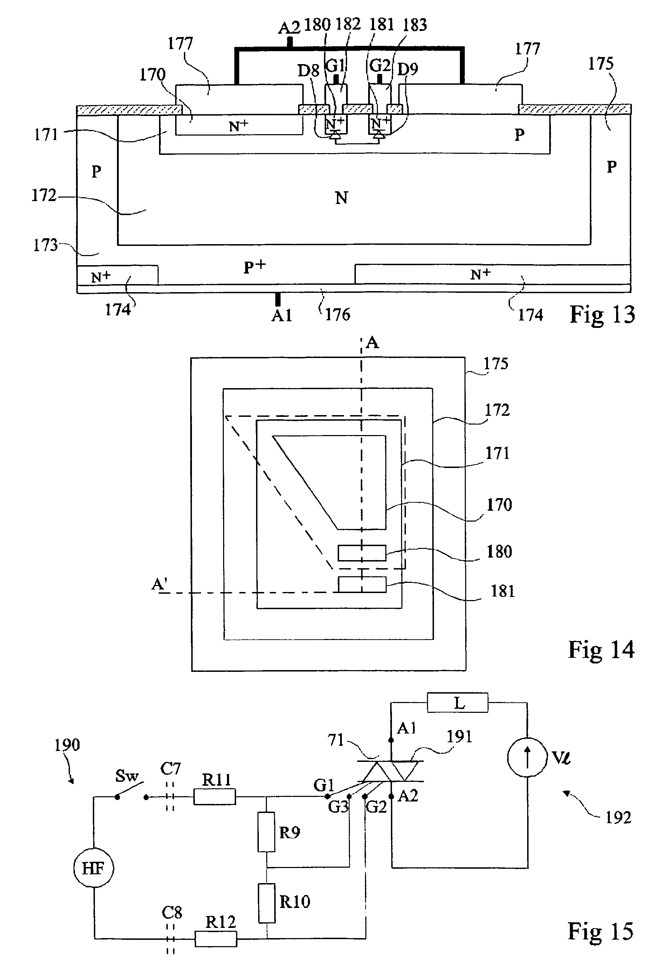

La figure 13 est une vue en coupe et la figure 14 une vue de dessus simplifiée d'un triac selon un autre mode de réalisation de la présente invention. La zone de puissance du triac est sensiblement identique à celle du triac de la figure 9 et comprend une région 170 de type N fortement dopée formée dans un caisson 171 de type P, lui-même formé dans un substrat 172 de type N faiblement dopé. Une couche 173 de type P fortement dopée est placée sous le substrat 172. Une région 174 de type N fortement dopée est formée dans la couche 173 du côté de la face arrière. Le substrat 172 est entouré d'un mur d'isolement constitué d'une couche 175 de type P faiblement dopé. Le caisson 171 a en vue de dessus une forme sensiblement rectangulaire. La région 170 a sensiblement la forme d'un rectangle tronqué auquel il manque un coin. La région 170 est placée sensiblement vers le haut du caisson 171. Le substrat 172 de forme sensiblement rectangulaire entoure le caisson 171. Le mur d'isolement 175 a une forme sensiblement rectangulaire et entoure le substrat 172. La région 174 de type N de face arrière est formée dans une grande partie de la couche 173 exceptée dans une portion de la couche 173 située à l'aplomb de la région 170 de type N. La portion de la couche 173 non occupée par la région 174 est représentée en pointillés sur la figure 14.

Les éléments spécifiques à un triac selon la présente invention font partie de la zone de commande définie ci-après. Deux régions 180 et 181 de type N fortement dopées sont formées dans le caisson 171 de type P. Les régions 180 et 181 ont en vue de dessus une forme sensiblement rectangulaire et sont placées sous la région 170, en bas à droite du caisson 171. Deux métallisations 182 et 183 sont en contact respectivement avec les régions 180 et 181 et sont reliées respectivement à deux bornes de gâchette G1 et G2. La région 180 de type N et le caisson 171 de type P constituent une diode D8 connectée aux bornes G1 et A2. La région 181 de type N et le caisson 171 de type P constituent une diode D9 connectée aux bornes G2 et A2. On pourra aussi prévoir un contact G3 sur le caisson 71, de façon analogue à ce qui est représenté en figure 7.

La figure 15 est un schéma d'un circuit de commande 190 d'un triac 191 inséré dans un circuit de puissance 192. Le triac 191 a la structure du triac représenté en figures 13 et 14. Le triac comprend des bornes de gâchette G1, G2 et G3. Le circuit de puissance 192 comprend un générateur de tension V1 et une charge L en série entre les bornes A1 et A2 du triac 191. Le triac 191 est relié au circuit de commande 190, comprenant un générateur HF et un interrupteur Sw en série, par l'intermédiaire d'un ensemble de résistances. Deux résistances R9 et R10 sont placées en série entre les bornes de gâchettes G1 et G2. Une résistance R11 est placée entre la borne de gâchette G1 et l'interrupteur Sw. Une résistance R12 est placée entre la borne de gâchette G2 et le générateur HF. Le point intermédiaire entre les résistances R9 et R10 est relié à la borne G3 (ou à la borne A2 du triac 191). Lorsque l'interrupteur Sw est fermé, le courant circule de R11 vers R12 lors d'une alternance du générateur HF et de R12 vers R11 lors de l'alternance suivante. Quand le courant circule de R11 vers R12, la diode D9 est passante et quand le courant circule de R12 vers R11, la diode D8 est passante.

Afin d'isoler galvaniquement le circuit de commande du triac 191, on pourra prévoir de placer deux condensateurs C7 et C8 entre la résistance R11 et l'interrupteur Sw et entre la résistance R12 et le générateur HF.

### 3. COMMUTATEUR BIDIRECTIONNEL COMMANDÉ

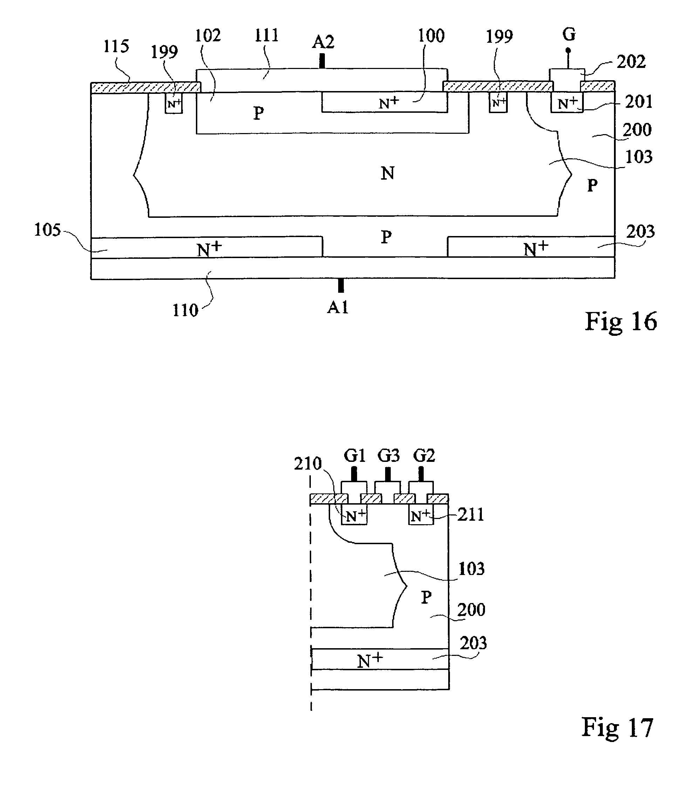

La figure 16 représente un commutateur bidirectionnel commandé classique dans lequel la tension de gâchette est référencée à la borne A1 de face arrière et non pas à la borne A2 de face avant. La partie de puissance d'un tel composant est similaire à la partie de puissance d'un triac classique tel qu'illustré en figure 9 et de mêmes éléments ont été désignés par de mêmes références. On a en outre représenté un anneau d'arrêt de canal 199 entourant la partie de puissance. Dans de tels composants, la région de gâchette est formée dans le mur latéral de type P 200. La partie de puissance comprend essentiellement une région 201 fortement dopée de type N formée du côté de la face supérieure du mur d'isolement et reliée par une métallisation 202 à une borne de gâchette G. On a également représenté une région N⁺ 203 complétant la région N⁺ 105 du côté de la face arrière de sorte que les régions N⁺ 105 et 203 recouvrent pratiquement toute la partie de la face arrière du composant non en regard de la région de type N⁺ 100. Comme on le voit, la région de gâchette est disposée dans le mur d'isolement lui-même solidaire de la borne A1. La tension sur la gâchette G est donc référencée à cette borne A1, ce qui dans de nombreux cas simplifie le montage et la commande d'un commutateur bidirectionnel pour lequel on souhaite que la face A1 soit reliée à un radiateur au potentiel de la masse.

Plusieurs moyens peuvent être utilisés pour transformer un tel commutateur bidirectionnel commandé en un commutateur commandé par HF selon la présente invention.

Un premier moyen (non représenté) consiste à insérer deux diodes telles que les diodes prévues dans les caissons 131 et 150 de la figure 11 au voisinage immédiat de la partie supérieure du mur d'isolement 200. Les porteurs s'accumuleront alors lors de l'application du signal HF et diffuseront dans le caisson vers la région P en contact avec l'électrode A1.

Un autre moyen est illustré en figure 17 et utilise une structure similaire à celle décrite en relation avec les figures 7 et 13 mais cette structure de déclenchement est alors placée dans la partie supérieure du mur d'isolement 200. Cette structure comprend une première région de type N 210 et une deuxième région de type N 211, respectivement connectées à des bornes G1 et G2. Un contact est repris sur la partie supérieure du mur d'isolement et est solidaire d'une borne G3. La commande de déclenchement se déduit aisément de ce qui a été décrit précédemment.

La présente invention s'applique à tout type de commutateur SCR comprenant au moins quatre couches semiconductrices "principales" de type de dopage alternés entre deux bornes principales de puissance. Un commutateur selon la présente invention comprend au moins deux régions de commande reliées à deux bornes de commande du commutateur. Ces régions de commande sont formées dans une couche principale du commutateur ou dans un caisson de commande spécifique formé dans une couche principale. Les régions de commande forment avec la couche principale et/ou la ou les caissons de commande dans lesquels elles sont formées deux diodes dont chacune, quand elle est passante, génère des porteurs susceptibles d'activer le commutateur. Les électrodes de chacune des diodes sont reliées à une borne de commande ou à une borne principale. En appliquant un signal haute fréquence aux bornes de chacune des diodes afin que chacune des deux diodes soit alternativement conductrice, il est possible d'avoir quasiment en permanence une diode conductrice qui injecte des porteurs. L'injection continue de porteurs de charge permet de diminuer de façon significative le temps d'activation du commutateur.

De plus, dans un commutateur SCR selon la présente invention, les éléments de commande et les éléments de puissance sont distincts ce qui permet d'optimiser leurs caractéristiques indépendamment les uns des autres.

Bien entendu, la présente invention est susceptible de diverses variantes et modifications qui apparaîtront à l'homme de l'art. En particulier, l'homme de l'art pourra imaginer divers modes de réalisation de deux diodes de commande dans une structure de commutateur SCR classique. De plus, l'homme de l'art saura concevoir d'autres circuits d'activation des deux diodes de commande d'un commutateur selon la présente invention.

## Revendications

1. Commutateur vertical de type SCR comprenant une zone de commande comprenant une première région de commande (60,61) formant une première diode avec une première région ou couche voisine, **caractérisé en ce que** :
la zone de commande comprend en outre une seconde région de commander (180,181) formant une seconde diode avec une seconde région ou couche voisine,
un contact est formé sur chacune des première et seconde régions de commande et sur chacune des première et seconde régions ou couches voisines,
lesdits contacts sont connectés à des bornes d'application d'une tension alternative de commande (91,92) de sorte que, quand une tension alternative est appliquée, chacune des deux diodes soit alternativement conductrice.

2. Commutateur vertical de type SCR selon la revendication 1, comprenant au moins quatre couches semiconductrices principales (50, 51, 52, 53 ; 170, 171, 172, 173, 174) de types de dopage alternés à travers lesquelles un courant important est susceptible de passer de la face avant à la face arrière entre deux bornes principales (A, K ; A1, A2), et dans lequel les première et deuxième régions de commande (60, 61 ; 180, 181) sont formées dans l'une (51 ; 171) des couches principales, les deux régions de commande formant avec la couche principale deux diodes (D3, D4 ; D8, D9) susceptibles chacune d'amorcer le commutateur, le commutateur pouvant être activé par un circuit appliquant une tension alternative telle que chacune des deux diodes soit alternativement conductrice.

3. Commutateur vertical de type SCR selon la revendication 1, comprenant au moins quatre couches semiconductrices principales (20, 21, 22, 23 ; 100, 102, 103, 104, 124) de types de dopage alternés à travers lesquelles un courant important est susceptible de passer de la face avant à la face arrière entre deux bornes principales (A, K ; A1, A2), et dans lequel les première et deuxième régions de commande (30, 32 ; 130, 132) sont formées respectivement dans l'une des couches principales (22 ; 102) et dans un caisson de commande (31 ; 131) formé dans l'une des couches principales (22 ; 103), les deux régions de commande formant respectivement avec la couche principale et le caisson de commande deux diodes (D3, D4 ; D5, D6) susceptibles chacune d'amorcer le commutateur, à une borne principale ou/et à une seconde borne de commande, le commutateur pouvant être activé par un circuit appliquant une tension alternative telle que chacune des deux diodes soit alternativement conductrice.

4. Commutateur vertical de type SCR selon la revendication 1, comprenant au moins quatre couches semiconductrices principales (100, 102, 103, 104, 124) de types de dopage alternés à travers lesquelles un courant important est susceptible de passer de la face avant à la face arrière entre deux bornes principales (171, 172), et dans lequel chacune des première et deuxième régions de commande (130, 132) est formée dans un caisson de commande (150, 131) formé dans l'une des couches principales (103), les deux régions de commande formant avec les caissons de commande dans lesquels elles sont formées deux diodes susceptibles chacune d'amorcer le commutateur, le commutateur pouvant être activé par un circuit appliquant une tension alternative telle que chacune des deux diodes soit alternativement conductrice.

5. Commutateur selon l'une quelconque des revendications 2 à 4, dans lequel la première couche principale est formée du côté de la face avant dans la deuxième couche principale, la deuxième couche et éventuellement la troisième et la quatrième couche principale débouchant du côté de la face avant, et dans lequel les deux régions de commande sont formées chacune dans l'une des deuxième, troisième ou quatrième couches, et le ou les caissons de commande sont formés dans l'une des troisième ou quatrième couches principales.

6. Commutateur selon la revendication 5 de type thyristor, comprenant quatre couches principales : une région de cathode (20 ; 50) d'un premier type de dopage du côté de la face supérieure, formée dans un caisson (21 ; 51) d'un second type de dopage, lui-même formé dans un substrat (22 ; 52) du premier type de dopage, et une région d'anode (23 ; 53) du second type de dopage formée du côté de la face arrière, la région de cathode étant reliée à une borne principale de cathode (K), la région d'anode étant reliée à une borne principale d'anode.

7. Commutateur selon la revendication 6, dans lequel les deux régions de commande sont des régions (60, 61) du premier type de dopage formées dans ledit caisson (51), une métallisation (64) reliée à une seconde borne de commande (G3) étant en contact avec ledit caisson.

8. Commutateur selon la revendication 6, dans lequel les deux régions de commande sont des première et seconde régions (30, 32) du premier type de dopage, la première région étant formée dans ledit caisson (21), la seconde région étant formée dans un second caisson (31) du second type de dopage formé dans ledit substrat (22), la première région étant reliée au second caisson et à une des bornes de commande (G1), la seconde région étant connectée audit caisson et à l'autre borne de commande (G2).

9. Commutateur selon la revendication 5 de type triac, comprenant cinq couches principales : une première région (120 ; 170) d'un premier type de dopage, formée dans un caisson (121 ; 171) d'un second type de dopage, lui-même formé dans un substrat (122 ; 172) du premier type de dopage, une couche (123 ; 173) du second type de dopage accolée à la partie inférieur du substrat et une seconde région (124 ; 174) du premier type de dopage formée dans la couche du côté de la face arrière, la première région et le caisson étant reliés en face avant à une borne principale (A1), la seconde région et ladite couche étant reliées en face arrière à l'autre borne principale (A2).

10. Commutateur selon la revendication 9, dans lequel les deux régions de commande sont des première et seconde régions (130, 132) du premier type de dopage, la première région étant formée dans ledit caisson (121), la seconde région étant formée dans un second caisson (131) du second type de dopage formé dans ledit substrat (122), la première région étant connectée au second caisson et à une des bornes de commande (G1), la seconde région étant connectée audit caisson et à l'autre borne de commande (G2).

11. Commutateur selon la revendication 9, dans lequel les deux régions de commande sont des première et seconde régions (130, 132) du premier type de dopage, formées respectivement dans des second et troisième caissons (150 ; 131) du second type de dopage formés dans ledit substrat (122), la première région étant reliée au troisième caisson et à une des bornes de commande (G1), la seconde région étant reliée au deuxième caisson et à l'autre borne de commande (G2).

12. Commutateur selon la revendication 9, dans lequel les deux régions de commande sont des régions (180, 181) du premier type de dopage formées dans ledit caisson (171).

13. Commutateur selon la revendication 1, de type commutateur bidirectionnel commandé, dans lequel la zone de commande est placée dans la partie supérieure d'un mur d'isolement (200) ou au voisinage immédiat de celle-ci.

## Claims

1. A vertical SCR-type switch comprising a control area comprising a first control region (60, 61) forming a first diode with a first neighboring region or layer, wherein:
the control area further comprises a second control region (180, 181) forming a second diode with a second neighboring region or layer,
a contact is formed on each of the first and second control regions and on each of the first and second neighboring regions or layers,
said contacts are connected to terminals of application of an A.C. control voltage (G1, G2) so that, when an A.C. voltage is applied, each of the two diodes is alternately conductive.

2. The vertical SCR-type switch of claim 1, comprising at least four "main" semiconductor layers (50, 51, 52, 53; 170, 171, 172, 173, 174) of alternate doping types through which a significant current is capable of running from the front surface to the rear surface between two main terminals (A, K; A1, A2), and wherein the first and second control regions (60, 61; 180, 181) are formed in one (51; 171) of the main layers, the two control regions forming with the main layer two diodes (D3, D4; D8, D9) capable of starting the switch, the switch being capable of being activated by a circuit applying an A.C. voltage such that each of the two diodes is alternately conductive.

3. The vertical SCR-type switch of claim 1, comprising at least four "main" semiconductor layers (20, 21, 22, 23; 100, 102, 103, 104, 124) of alternate doping types through which a significant current is capable of running from the front surface to the rear surface between two main terminals (A, K; A1, A2), and wherein the first and second control regions (30, 32; 130, 132) are respectively formed in one of the main layers (22; 102) and in a control well (31; 131) formed in one of the main layers (23; 103), the two control regions respectively forming with the main layer and the control well two diodes (D3, D4; D5, D6) each capable of starting the switch, at a main terminal and/or at a second control terminal, the switch being capable of being activated by a circuit applying an A.C. voltage such that each of the two diodes is alternately conductive.

4. The vertical SCR-type switch of claim 1, comprising at least four "main" semiconductor layers (100, 102, 103, 104, 124) of alternate doping types through which a significant current is capable of running from the front surface to the rear surface between two main terminals (171, 172), and wherein each of the first and second control regions (130, 132) is formed in a control well (150, 131) formed in one of the main layers (103), the two control regions forming with the control wells in which they are formed two diodes each capable of starting the switch, the switch being capable of being activated by a circuit applying an A.C. voltage such that each of the two diodes is alternately conductive.

5. The switch of any of claims 2 to 4, wherein the first main layer is formed on the front surface side in the second main layer, the second layer and possibly the third and the fourth main layers emerging on the front surface side, and the two control regions are each formed in one of the second, third, or fourth layers, and the control well(s) are formed in one of the third or fourth main layers.

6. The switch of claim 5, of thyristor type, comprising four main layers: a cathode region (20; 50) of a first doping type on the upper surface side, formed in a well (21; 51) of a second doping type, itself formed in a substrate (22; 52) of the first doping type, and an anode region (23; 53) of the second doping type formed on the rear surface side, the cathode region being connected to a main cathode terminal (K), the anode region being connected to a main anode terminal.

7. The switch of claim 6, wherein the two control regions are regions (60, 61) of the first doping type formed in said well (51), a metallization (64) connected to a second control terminal (G3) being in contact with said well.

8. The switch of claim 6, wherein the two control regions are first and second regions (30, 32) of the first doping type, the first region being formed in said well (21), the second region being formed in a second well (31) of the second doping type formed in said substrate (22), the first region being connected to the second well and to one of the control terminals (G1), the second region being connected to said well and to the other control terminal (G2).

9. The switch of claim 5 of triac type, comprising five main layers: a first region (120; 170) of a first doping type, formed in a well (121; 171) of a second doping type, itself formed in a substrate (122; 172) of the first doping type, a layer (123; 173) of the second doping type adjacent to the lower portion of the substrate and a second region (124; 174) of the first doping type formed in the layer on the rear surface side, the first region and the well being connected at its front surface to a main terminal (A1), the second region and said layer being connected at their rear surface to the other main terminal (A2).

10. The switch of claim 9, wherein the two control regions are first and second regions (130, 132) of the first doping type, the first region being formed in said well (121), the second region being formed in a second well (131) of the second doping type formed in said substrate (122), the first region being connected to the second well and to one of the control terminals (G1), the second region being connected to said well and to the other control terminal (G2).

11. The switch of claim 9, wherein the two control region are first and second regions (130, 132) of the first doping type, respectively formed in second and third wells (150; 131) of the second doping type formed in said substrate (122), the first region being connected to the third well and to one of the control terminals (G1), the second region being connected to the second well and to the other control terminal (G2).

12. The switch of claim 9, wherein the two control regions are regions (180, 181) of the first doping type formed in said well (171).

13. The switch of claim 1, of controlled bidirectional type, wherein the control area is placed in the upper portion of an insulating wall (200) or in the immediate vicinity thereof.

## Patentansprüche

1. Vertikaler SCR-Schalter, der einen Steuerbereich aufweist, der einen ersten Steuerbereich (60, 61) aufweist, der eine erste Diode mit einem ersten benachbarten Bereich oder einer ersten benachbarten Schicht bildet, wobei:
der Steuerbereich weiter einen zweiten Steuerbereich (180, 181) aufweist, der eine zweite Diode mit einem zweiten benachbarten Bereich oder einer zweiten benachbarten Schicht bildet,
wobei ein Kontakt auf sowohl dem ersten als auch dem zweiten Steuerbereich und auf jedem der ersten und zweiten benachbarten Bereiche oder der benachbarten Schichten geformt ist,
wobei die Kontakte mit Anschlüssen verbunden sind, an denen eine Wechselstromsteuerspannung (G1, G2) angelegt ist, so dass, wenn eine Wechselstromspannung angelegt ist, jede der zwei Dioden abwechselnd leitend ist.

2. Vertikaler SCR-Schalter nach Anspruch 1, der zumindest vier "Haupt"-Halbleiterschichten (50, 51, 52, 53; 170, 171, 172, 173, 174) der Bauart mit abwechselnder Dotierung aufweist, durch welche ein beträchtlicher Strom von der Vorderseite zur Rückseite zwischen zwei Hauptanschlüssen (A, K; A1, A2) laufen kann, und wobei die ersten und zweiten Steuerbereiche (60, 61; 180, 181) in einer Schicht (51; 171) der Hauptschichten geformt sind, wobei die zwei Steuerbereiche mit der Hauptschicht zwei Dioden (D3, D4; D8, D9) formen können, die den Schalter starten können, wobei der Schalter durch eine Schaltung aktiviert werden kann, die eine Wechselstromspannung anlegt, und zwar derart, dass jede der zwei Dioden abwechselnd leitend wird.

3. Vertikaler SCR-Schalter nach Anspruch 1, der zumindest vier "Haupt"-Halbleiterschichten (20, 21, 22, 23; 100, 102, 103, 104, 124) mit abwechselnd dotierter Bauart aufweist, durch welche ein beträchtlicher Strom von der Vorderseite zur Rückseite zwischen zwei Hauptanschlüssen (A, K; A1, A2) fließen kann, und wobei die ersten und zweiten Steuerbereiche (30, 32; 130, 132) jeweils in einer der Hauptschichten (22; 102) und in einer Steuerquelle (31; 131) geformt sind, die in einer der Hauptschichten (23; 103) ausgeformt ist, wobei die zwei Steuerbereiche jeweils mit der Hauptschicht und der Steuerquelle zwei Dioden (D3, D4; D5, D6) bilden, die jeweils den Schalter an einem Hauptanschluss und/oder an einem zweiten Steueranschluss starten können, wobei der Schalter durch eine Schaltung aktiviert werden kann, die eine Wechselstromspannung derart anlegt, dass jede der zwei Dioden abwechselnd leitend ist.

4. Vertikaler SCR-Schalter nach Anspruch 1, der zumindest vier "Haupt"-Halbleiterschichten (100, 102, 103, 104, 124) mit abwechselnd dotierter Bauart aufweist, durch die ein beträchtlicher Strom von der Vorderseite zur Rückseite zwischen zwei Hauptanschlüssen (171, 172) fließen kann, und wobei jeder der ersten und zweiten Steuerbereiche (130, 132) in einer Steuerquelle (150, 131) geformt ist, die in einer der Hauptschichten (103) gebildet ist, wobei die zwei Steuerbereiche mit den Steuerquellen, in denen sie geformt sind, zwei Dioden bilden, die jeweils den Schalter starten können, wobei der Schalter durch eine Schaltung aktiviert werden kann, die eine Wechselstromspannung anlegt, so dass jede der zwei Dioden abwechselnd leitend wird.

5. Schalter nach einem der Ansprüche 2 bis 4, wobei die erste Hauptschicht auf der Vorderseite in der zweiten Hauptschicht gebildet ist, wobei die zweite Schicht und möglicherweise die dritten und vierten Hauptschichten auf der Vorderseite hervortreten, und wobei die zwei Steuerbereiche jeweils in einer der zweiten, dritten oder vierten Schichten geformt sind, und wobei die Steuerquelle(n) in einer der dritten oder vierten Hauptschichten geformt ist (sind).

6. Schalter nach Anspruch 5, der eine Thyristor-Bauart aufweist, die vier Hauptschichten aufweist: einen Kathodenbereich (20; 50) einer ersten Dotierungsart auf der Oberseite, die in einer Quelle (21; 51) einer zweiten Dotierungsart geformt ist, die selbst in einem Substrat (22; 52) der ersten Dotierungsart gebildet ist, und einen Anodenbereich (23; 53) der zweiten Dotierungsart, der auf der Hinterseite geformt ist, wobei der Kathodenbereich mit einem Hauptkathodenanschluss (K) verbunden ist, wobei der Anodenbereich mit einem Hauptanodenanschluss verbunden ist.

7. Schalter nach Anspruch 6, wobei die zwei Steuerbereiche Bereiche (60, 61) der ersten Dotierungsart sind, die in der Quelle (51) geformt sind, wobei eine Metallisierung (64), die mit einem zweiten Steueranschluss (G3) verbunden ist, in Kontakt mit der Quelle ist.

8. Schalter nach Anspruch 6, wobei die zwei Steuerbereiche erste und zweite Bereiche (30, 32) der ersten Dotierungsart sind, wobei der erste Bereich in der Quelle (21) geformt ist, wobei der zweite Bereich in einer zweiten Quelle (31) der zweiten Dotierungsart Bauart geformt ist, die in dem Substrat (22) ausgebildet ist, wobei der erste Bereich mit der zweiten Quelle und mit einem der Steueranschlüsse (G1) verbunden ist, wobei der zweite Bereich mit der Quelle und dem anderen Steueranschluss (G2) verbunden ist.

9. Schalter nach Anspruch 5, der eine Triac-Bauart aufweist, die fünf Hauptschichten aufweist: einen ersten Bereich (120; 170) einer ersten Dotierungsart, der in einer Quelle (121; 171) einer zweiten Dotierungsart geformt ist, die selbst in einem Substrat (122; 172) der ersten Dotierungsart geformt ist, eine Schicht (123; 173) der zweiten Dotierungsart, die benachbart zum unteren Teil des Substrats und einem zweiten Bereich (124; 174) der ersten Dotierungsart ist, die in der Schicht auf der Rückseite geformt ist, wobei der erste Bereich und die Quelle an ihrer Vorderseite mit einem Hauptanschluss (A1) verbunden sind, wobei der zweite Bereich und die Schicht an ihrer Rückseite mit dem anderen Hauptanschluss (A2) verbunden sind.

10. Schalter nach Anspruch 9, wobei die zwei Steuerbereiche erste und zweite Bereiche (130, 132) der ersten Dotierungsart sind, wobei der erste Bereich in der Quelle (121) geformt ist, und wobei der zweite Bereich in einer zweiten Quelle (131) der zweiten Dotierungsart ausgeformt ist, die in dem Substrat (122) geformt ist, wobei der erste Bereich mit der zweiten Quelle und mit einem der Steueranschlüsse (G1) verbunden ist, wobei der zweite Bereich mit der Quelle und dem anderen der Steueranschlüsse (G2) verbunden ist.

11. Schalter nach Anspruch 9, wobei die zwei Steuerbereiche erste und zweite Bereiche (130, 132) der ersten Dotierungsart sind, die jeweils in zweiten und dritten Quellen (150; 131) der zweiten Dotierungsart geformt sind, die in dem Substrat (122) ausgebildet sind, wobei der erste Bereich mit der dritten Quelle und mit einem der Steueranschlüsse (G1) verbunden ist, wobei der zweite Bereich mit der zweiten Quelle und dem anderen der Steueranschlüsse (G2) verbunden ist.

12. Schalter nach Anspruch 9, wobei die zwei Steuerbereiche Bereiche (180, 181) der ersten Dotierungsart sind, die in der Quelle (171) ausgebildet sind.

13. Schalter nach Anspruch 1, der eine gesteuerte bi-direktionale Bauart aufweist, wobei der Steuerbereich in dem oberen Teil einer isolierenden Wand (200) oder in direkter Nachbarschaft dazu angeordnet ist.
